# EUROPEAN PATENT APPLICATION

(11) **EP 4 492 077 A2**
(43) Date of publication of application: **15.01.2025**
(21) Application number: 24187555.8
(22) Date of filing: 09.07.2024
(51) Int. Cl.: G01R 33/032, G01R 33/12, G01N 21/95, G03F 7/00, G01R 33/10

(54) **WAFER INSPECTION APPARATUS AND METHOD OF INSPECTING WAFER USING SAME**

(30) Priority: 13.07.2023 KR 20230090841
(71) Applicant: Korea Research Institute of Standards and Science, Daejeon 34113 (KR)
(72) Inventor: HWANG, Chan Yong, 06603 Seoul (KR); MOON, Kyoung Woong, 34121 Daejeon (KR); KIM, Chang Soo, 06325 Seoul (KR); LEE, Sang Sun, 34022 Daejeon (KR); YANG, Seung Mo, 34061 Daejeon (KR)
(74) Representative: Fuchs Patentanwälte Partnerschaft mbB

(57) **Abstract**

Proposed are a wafer inspection apparatus and a method of inspecting a wafer using the wafer inspection apparatus. The proposed wafer inspection apparatus includes a horizontal magnetic field generation unit arranged proximate to a lateral surface of a wafer and forming a magnetic field in such a manner that lines of magnetic force propagate in a horizontal direction, a vertical magnetic field generation unit arranged under the wafer and generating a magnetic field in such a manner that lines of magnetic force propagate in a direction vertical to the wafer, an image measurement unit arranged over the wafer and measuring an image of the wafer, and a wafer movement stage moving the wafer in a first direction and a second direction.

## Description

### CROSS REFERENCE TO RELATED APPLICATION

The present application claims priority to Korean Patent Application No. 10-2023-0090841, filed July 13, 2023, the entire contents of which is incorporated herein for all purposes by this reference.

### BACKGROUND OF THE INVENTION

### Field of the Invention

The present invention relates to a wafer inspection apparatus and, more particularly, to a wafer inspection apparatus capable of determining the uniformity of a magnetic property by evaluating the uniformity of stripes on a surface of a wafer and a method of inspecting a wafer using the wafer inspection apparatus.

### Description of the Related Art

In the related art, methods of measuring a magnetic property of a wafer, such as a method of measuring the magnetic moment of a magnetic body using a vibrating sample magnetometer or a squid (superconducting quantum interference device) magnetometer, a sign method that uses a compass, and a method of measuring a distance-varying magnetic flux density, have been employed to measure the magnetism, such as the magnetic moment, of a magnetic thin film formed on top of a wafer by deposition.

In addition to these methods, in the related art, there have been proposed technologies and apparatuses that measure a magnetic property of the wafer through electric measurement, optical measurement, the changing of a magnetic field by an electromagnet, or the like.

Among these technologies, those that measure the magnetic property of the wafer through the electric measurement infer the magnetic characteristic by observing a change in the resistance of a surface of the wafer using a contact tip. Thus, they generate a change in resistance that varies according to a magnetization direction, thereby measuring the magnetic property of the wafer.

However, a method that uses this change in resistance of the surface of the wafer requires the presence of a contact unit, for example, a contact trace. Furthermore, this method may cause thermal damage due to the concentration of electric current on the contact unit and has constraints in spatial resolution.

In addition, a problem arises in that a measurement region of the wafer is obscure and that time is required for magnetic field scanning.

For the optical measurement, there has been proposed a method for measuring the magnetic property of the wafer by measuring a characteristic of light reflected from the wafer, for example, the reflection ratio, the polarization direction, and the like.

However, in this optical measurement, spatial resolution with optical constraints is possible. Furthermore, much time is required to scan all regions of the wafer because only one point is observed at a time. Additionally, the motion of a magnetic domain wall makes the measurement results obscure, and time is required for magnetic field scanning.

In addition, a method of measuring the magnetic property of the wafer through the changing of a magnetic field by an electromagnet requires time to change the magnetic field. Because of this, a change in the magnetic field is suppressed by the inductance of the electromagnet, thereby interrupting high-speed measurement.

Therefore, much time is required to scan all regions of the wafer, and the measurement results are obscure. Consequently, there has been a demand for technologies capable of solving problems such as constraints in spatial resolution.

### SUMMARY OF THE INVENTION

An object of the present invention is to provide a wafer inspection apparatus capable of forming a stripe state by applying a horizontal magnetic field to a surface of a wafer and thus of determining the uniformity of a magnetic property by evaluating the uniformity of stripes and a method of inspecting a wafer using the wafer inspection apparatus.

In order to accomplish the above-mentioned object, according to an aspect of the present invention, there is provided a wafer inspection apparatus that broadly includes an image measurement unit, a magnetic field generation unit, and a wafer movement stage.

The magnetic field generation unit includes a horizontal magnetic field generation unit for applying a magnetic field in a direction that runs alongside a surface of a wafer.

A stage capable of adjusting the angle of the wafer may be installed to accurately align the horizontal magnetic field generation unit with the surface of the wafer. Thus, the angle between the wafer and a horizontal magnetic field may be adjusted. Alternatively, a vertical magnetic field generation unit may be additionally installed.

Accordingly, a vertical magnetic field, which occurs due to misalignment of the horizontal magnetic field, may be canceled out.

Through the additionally installed vertical magnetic field generation unit, a magnetic field that cancels out the vertical magnetic field occurring due to the misalignment of the horizontal magnetic field may be generated.

The horizontal magnetic field generation units may be arranged proximate to both lateral surfaces, respectively, of the wafer in such a manner as to face each other, in order to generate a uniform magnetic field within an imaging region.

When the imaging region is sufficiently small, the horizontal magnetic field generation units may not need to be arranged proximate to both lateral surfaces, respectively, of the wafer. Instead, the single horizontal magnetic field generation unit may also be arranged proximate to only one lateral surface of the wafer and used.

For the purpose of accurately aligning the horizontal magnetic field with a sample surface, a tilting stage for adjusting the angle of the sample may be further included.

As long as imaging is possible, any method may be used. Therefore, visible light or an electron beam may be used as light, and any light may also be used.

The wafer inspection apparatus according to the present invention forms a stripe state on the wafer by applying the horizontal magnetic field to the wafer. Thus, positions of defects of stripes in all regions of the wafer can be recognized, and the uniformity of the wafer can be evaluated. Consequently, the uniformity of a magnetic property can be effectively measured.

In addition, it is possible that the wafer inspection apparatus according to the present invention moves the position of the wafer in such a manner that all regions of the wafer can be imaged, using the wafer movement stage.

The present invention is not limited to the effects mentioned above. From the following description, effects not mentioned would be clearly understood by a person of ordinary skill in the art to which the present invention pertains.

### BRIEF DESCRIPTION OF THE DRAWINGS

FIG. 1 is a perspective view illustrating a wafer inspection apparatus according to an embodiment of the present invention.
FIG. 2 is a cross-sectional view taken along line II-II' on FIG. 1, illustrating the wafer inspection apparatus.
FIG. 3 is a perspective view illustrating an image measurement unit of the wafer inspection apparatus according to the embodiment of the present invention.
FIGS. 4A to 4C are views each illustrating the result of observing a surface of a wafer through the image measurement unit of the wafer inspection apparatus according to the embodiment of the present invention.
FIG. 5 is a perspective view illustrating horizontal magnetic field generation units of the wafer inspection apparatus according to the embodiment of the present invention, the horizontal magnetic field generation units being arranged proximate to both lateral surfaces, respectively, of the wafer in such a manner as to face each other.
FIG. 6 is a perspective view illustrating a vertical magnetic field generation unit, arranged under the wafer, of the wafer inspection apparatus according to the embodiment of the present invention.
FIG. 7 is a perspective view illustrating a wafer movement stage of the wafer inspection apparatus according to the embodiment of the present invention, the wafer movement stage being capable of moving the wafer backward, forward, leftward, and rightward.
FIG. 8 is a flowchart schematically illustrating a process of measuring the uniformity of a magnetic property of the wafer using the wafer inspection apparatus according to the embodiment of the present invention.
FIG. 9 is a view schematically illustrating a magnetic thin film deposited on top of the wafer and a finely patterned state of the magnetic thin film, which are measured using the wafer inspection apparatus according to the embodiment of the present invention.
FIG. 10A is a view illustrating a uniform distribution of properties of stripes on a surface of the wafer, which are measured using the wafer inspection apparatus according to the embodiment of the present invention.
FIG. 10B is a view illustrating defects in the distribution of the properties of the stripes on the surface of the wafer, which are measured using the wafer inspection apparatus according to the embodiment of the present invention.
FIG. 11A is a schematic perspective view illustrating a state where a horizontal magnetic field is applied to the surface of the wafer in a parallel manner, using the wafer inspection apparatus according to the embodiment of the present invention.
FIG. 11B is a view schematically illustrating a stripe state of the surface of the wafer, which results from the intensity of the applied horizontal magnetic field when applying the horizontal magnetic field to the surface of the wafer.
FIG. 12A is a view schematically illustrating non-uniform states of widths of the stripes, which are among defect types of the stripes on the wafer, which are measured when applying the horizontal magnetic field in a parallel manner to the surface of the wafer, using the wafer inspection apparatus according to the embodiment of the present invention.
FIG. 12B is a view schematically illustrating non-uniform states of directions of the stripes, which are among defect types of the stripes on the wafer, which are measured when applying the horizontal magnetic field in a parallel manner to the surface of the wafer, using the wafer inspection apparatus according to the embodiment of the present invention.
FIG. 12C is a view schematically illustrating non-uniform states of ratios of the stripes, which are among defect types of the stripes on the wafer, which are measured when applying the horizontal magnetic field in a parallel manner to the surface of the wafer, using the wafer inspection apparatus according to the embodiment of the present invention.

### DETAILED DESCRIPTION OF THE INVENTION

Preferred embodiments of the present invention will be described in detail below with reference to the accompanying drawings.

However, the technical idea of the present invention is not limited to the preferred embodiment described below and may be implemented into various different forms. At least one of the constituent elements may be used through selective combination or substitution among the preferred embodiments, within the scope of the technical idea of the present invention.

In addition, unless otherwise specifically defined and described, the terms (including the technical and scientific terms), used in the preferred embodiments of the present invention, may be interpreted as having meanings normally understandable to a person of ordinary skill in the art to which the present invention pertains. The terms normally used, similar to those defined in a dictionary, may be interpreted as having their meanings, considering their contextual meanings within the relevant technology.

In addition, the terms, used in the preferred embodiments of the present invention, serve to describe the preferred embodiments, and are not intended to impose any limitation on the scope of the present invention.

Throughout the present specification, unless otherwise specified in a sentence, a noun in singular form may have the same meaning as in plural form. The expression 'at least one (or one or more) of the following: A, B, and C' may be interpreted as one or more selected from the group consisting of A, B, and C.

In addition, in describing constituent elements of each of the preferred embodiments of the present invention, the ordinal numbers first, second, and so forth, the upper case letters A, B, and so forth, and the parenthesized lower case letters (a), (b), and so forth may be used.

These terms serve only to distinguish among constituent elements and do not impose any limitation on the features of the constituent elements, the order or sequence of the constituent elements, or the like.

In addition, in a case where one constituent element is 'connected to,' 'coupled to,' or 'accesses' another constituent element, they may be directly connected to, coupled to, or access each other and may be connected to, coupled to, or access each other with a third constituent element in between.

In addition, in a case where one constituent element is described as formed or arranged on top of or underneath another constituent element, they may be in direct contact with each other. In a case where one constituent element is described as formed or arranged over (above) or under (below) another constituent element, it may be formed or arranged directly over (above) or under (below) the other constituent element, or with a third constituent element in between. In addition, the expression 'on top of' or 'underneath,' as well as the expression 'over (above)' or 'under (below),' may also be used in the opposite direction with respect to one constituent element.

When the preferred embodiments are described in detail below with reference to the accompanying drawings, constituents that are the same or correspond to each other are assigned like reference numerals, and the same description is not repeated.

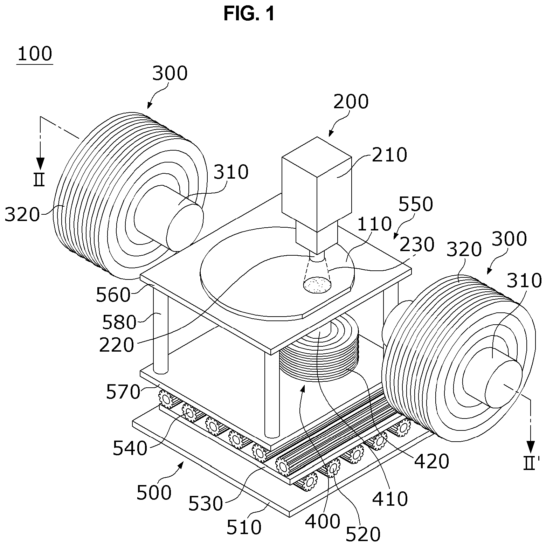

FIG. 1 is a perspective view illustrating a wafer inspection apparatus 100 according to an embodiment of the present invention.

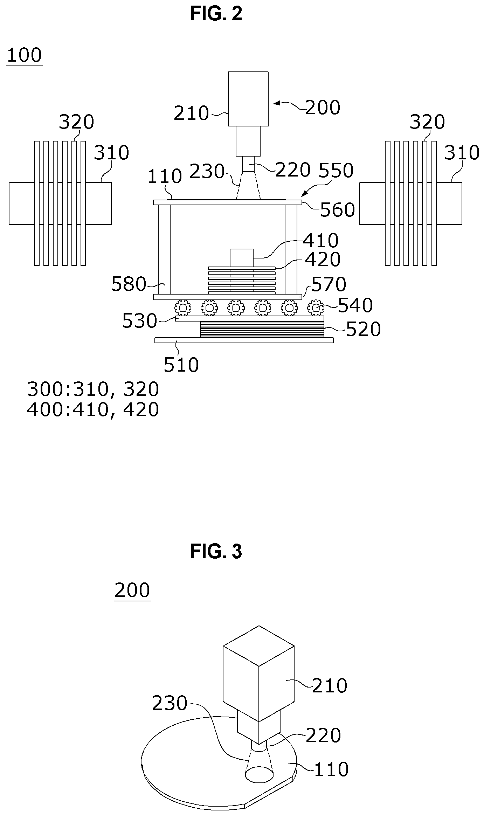

FIG. 2 is a cross-sectional view taken along line II-II' on FIG. 1, illustrating the wafer inspection apparatus 100.

With reference to FIGS 1 and 2, the wafer inspection apparatus 100 according to the embodiment of the present invention may include an image measurement unit 200, a magnetic field generation unit (not illustrated), and a wafer movement stage 500.

The magnetic field generation unit includes a horizontal magnetic field generation unit 300 for applying a magnetic field in a direction that runs alongside a lateral side of the wafer 110.

A tilting stage for adjusting an angle of the wafer 110 is installed to accurately align the horizontal magnetic field generation unit 300 with a surface of the wafer 110. Thus, the angle between the wafer 110 and a horizontal magnetic field may be adjusted. Alternatively, a vertical magnetic field generation unit 400 may be additionally installed.

Accordingly, a vertical magnetic field, which occurs due to misalignment of the horizontal magnetic field, may be canceled out.

Through the vertical magnetic field generation unit 400 additionally installed, a magnetic field that cancels out the vertical magnetic field, which occurs due to the misalignment of the horizontal magnetic field, may be generated.

The horizontal magnetic field generation units 300 may be arranged proximate to both lateral surfaces, respectively, of the wafer 110 in such a manner as to face each other, in order to generate a uniform magnetic field within an imaging region. However, the horizontal magnetic field generation units 300 are not limited to this arrangement.

Particularly, when the imaging region is sufficiently small, the horizontal magnetic field generation units 300 may not need to be arranged proximate to both lateral surfaces, respectively, of the wafer 110. Instead, the single horizontal magnetic field generation unit 300 may also be arranged proximate to only one lateral surface of the wafer 110 and used.

For the purpose of accurately aligning the horizontal magnetic field with a sample surface, a tilting stage for adjusting an angle of the sample may be further included.

As long as imaging is possible, any method may be used. Therefore, visible light or an electron beam may be used as light, and any light may also be used.

A wafer inspection apparatus 100 may include an image measurement unit 200 that is arranged at a predetermined distance over a wafer 110 and measures an image of the wafer 110; a horizontal magnetic field generation unit 300, forming a magnetic field with lines of magnetic force propagating in a horizontal direction, that is arranged proximate to one lateral surface of the wafer 110 on which a magnetic thin film is formed, or horizontal magnetic field generation units 300, forming a magnetic field with lines of magnetic force propagating in a horizontal direction, that are arranged proximate to both lateral surfaces, respectively, of the wafer 110 on which a magnetic thin film is formed, in such a manner as to face each other; a vertical magnetic field generation unit 400 that is arranged under the wafer 110 and generates a magnetic field canceling out a vertical field occurring due to misalignment of a horizontal magnetic field; and a wafer movement stage 500 that moves the wafer 110 backward, forward, leftward, and rightward.

FIG. 3 is a perspective view illustrating the image measurement unit 200 of the wafer inspection apparatus 100 according to the embodiment of the present invention.

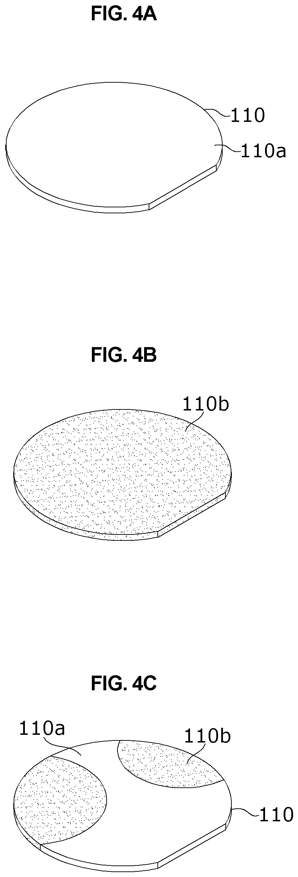

FIGS. 4A to 4C are views each illustrating the result of observing the surface of the wafer 110 through the image measurement unit 200 of the wafer inspection apparatus 100 according to the embodiment of the present invention.

With reference to FIG. 3, the image measurement unit 200 may include a microscope body portion 210 that generates a magneto optic effect and a light emission unit 220.

The phtomagnetic effect refers to a range of phenomena, such as reflection, refraction, transmission, and absorption, that occur when light is incident on a sample. Through a microscope, light that causes the magneto optic effect may be observed.

The image measurement unit 200 may emit light 230 onto the surface of the wafer 110 through the light emission unit 220 of the microscope body portion 210 in a state of being arranged at a predetermined distance over the wafer 110. Then, the image measurement unit 200 may obtain an image using the light 230 passing through the surface of the wafer 110 and may recognize a material-related magnetic or magnetized state of the surface of the wafer 110 using the diffracted light 220. That is, the magnetized state of the surface of the wafer 110 may be recognized by observing the light reflected from a sample portion of the surface of the wafer 110.

Examples of the light 230 include an electron beam, visible light, and the like. In most cases, visible light may be used as the light 230. However, the light 230 is not limited to these.

As the light 230, imaging rays and imaging light are considered to be more suitable than an 'electron beam.'

The magneto optic effect or a surface photomagnetic effect, which is one of the photomagnetic effects, results from a change in light reflected from a magnetized surface. In order to illuminate a magnetized structure of a material, the magneto optic effect is used in apparatuses such as microscopes.

The magneto optic effect is associated with light reflected from the magnetized surface and may change both polarization intensity and reflection intensity. The magneto optic effect may be considered to be similar to the Faraday effect, which explains a change in light transmission by a magnetic material.

With reference to FIGS. 4A to 4C, the image measurement unit 200 emits the light 230 to the surface of the wafer 110 and observes an up-magnetized region 110a and a down-magnetized region 110b of the surface of the wafer 110.

With reference to FIG. 4A, the surface of the wafer 110, when it all becomes the up-magnetized region 110a, may be in a uniform state.

With reference to FIG. 4B, the surface of the wafer 110, when it all becomes the down-magnetized region 11 0b, may be in a uniform state.

With reference to FIG. 4C, the surface of the wafer 110, when it has the up-magnetized region 110a and the down-magnetized region 11 0b, may be in a divided state.

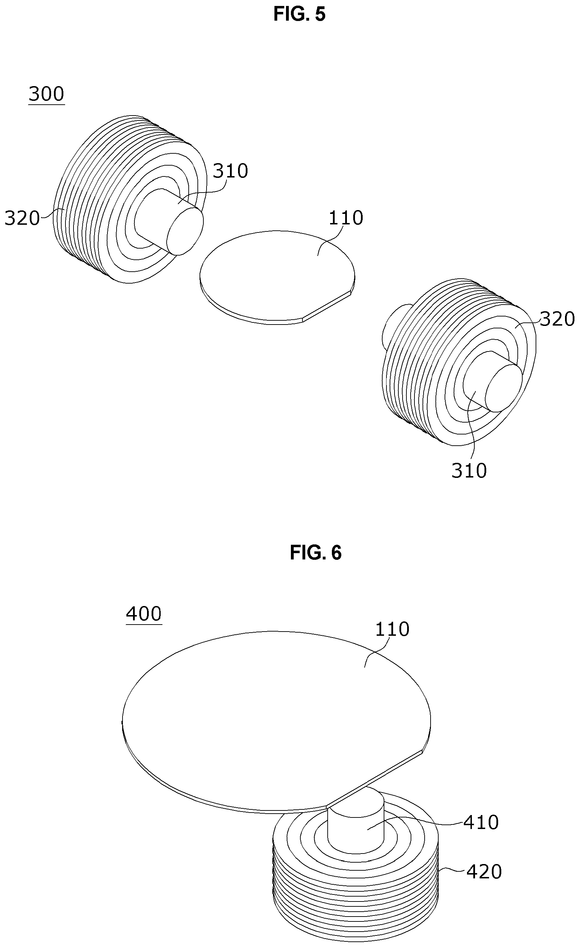

FIG. 5 is a perspective view illustrating the horizontal magnetic field generation units 300 of the wafer inspection apparatus 100 according to the present invention, the horizontal magnetic field generation units being arranged proximate to both lateral surfaces, respectively, of the wafer 100 in such a manner as to face each other.

With reference to FIG. 5, the horizontal magnetic field generation unit 300 may be configured to include a horizontal magnetic body 310 and a first coil 320 wound around an external surface of the horizontal magnetic body 310.

A normal electromagnet may be configured in the form of a coil wound around an iron core. A device in any form that can generate a magnetic field may serve as the horizontal magnetic body 310.

An electromagnet with only a coil may be used as the horizontal magnetic body 310. The technique of changing the magnitude of a magnetic field by adjusting a distance to a permanent magnet may also be employed.

The horizontal magnetic field generation units 300 may be arranged proximate to both lateral surfaces, respectively, of the wafer 110 in such a manner that they face each other with a predetermined distance between them.

The horizontal magnetic body 310 guides lines of magnetic force toward the wafer 110. That is, the horizontal magnetic bodies 310 guide lines of magnetic force toward both lateral surfaces, respectively, of the wafer 110, on which the magnetic thin film is formed, in such a manner as to face a direction parallel to the wafer 110. A magnet or an electromagnet may be used as the horizontal magnetic body 310.

It is preferred that the first coil 320 is wound in such a manner as to surround at least one portion of the horizontal magnetic body 310, so that the first coil 320 is supplied from the outside and the horizontal magnetic body 310 guides lines of magnetic force, thereby forming a magnetic field.

A magnetic field is applied to a measurement region of the wafer 110, on which the magnetic thin film is formed, in order to measure a magnetic nature such as magnetic moment or effective saturation magnetization.

A magnetic field may be applied in such a manner that lines of magnetic force pass in a direction parallel to the surface of the wafer 110. Therefore, a magnetic field accurately aligned with the surface of the wafer 110 is generated from the horizontal magnetic field generation unit 300.

It is preferred that the magnitude of the magnetic field from the horizontal magnetic field generation unit 300 is maintained at a level sufficient to trigger stripe generation. Particularly, it is preferred that a magnetic field that can cancel out the property of maintaining vertical magnetism is applied.

The intensity of the magnetic field needs to be approximately the magnitude of an effective magnetic field due to a magnetic anisotropy .

FIG. 6 is a perspective view illustrating the vertical magnetic field generation unit 400, arranged under the wafer 110, of the wafer inspection apparatus 100 according to the embodiment of the present invention.

With reference to FIG. 6, the vertical magnetic field generation unit 400 may be configured to include a vertical magnetic body 410 and a second coil 420 wound around an external surface of the vertical magnetic body 410.

The vertical magnetic field generation unit 400 may be arranged under the wafer 110 in a manner that is separated by a predetermined distance from the wafer 110.

The vertical magnetic field generation unit 400 may be arranged in a manner that is separated by a predetermined distance from the wafer movement stage 500.

The vertical magnetic body 410 guides lines of magnetic force toward the wafer 110. That is, the vertical magnetic body 410 guides lines of magnetic force toward the wafer 110, on which the magnetic thin film is formed, in such a manner as to face a direction vertical to the wafer 110. A magnet or an electromagnet may be used as the vertical magnetic body 410.

It is preferred that the second coil 420 is wound in such a manner as to surround at least one portion of the vertical magnetic body 410, so that the second coil 420 is supplied from the outside and the vertical magnetic body 410 guides lines of magnetic force, thereby forming a magnetic field.

A magnetic field is applied to a measurement region of the wafer 110, on which the magnetic thin film is formed, in order to measure a magnetic nature such as magnetic moment or effective saturation magnetization.

At this point, a magnetic field may be applied in such a manner that lines of magnetic force pass in a direction vertical to the surface of the wafer 110.

It is preferred that the magnetic field has such a magnitude that the magnetized state of the wafer 110 can be changed from an up-magnetized state to a down-magnetized state or from the down-magnetized state to the up-magnetized state. Particularly, the magnetic field needs to have such a high magnitude that magnetization can be reversed. It is possible to correct the slope of the horizontal magnetic field.

Particularly, the vertical magnetic field generation unit 400 may be arranged under the wafer 110 and may generate the magnetic field that cancels out the vertical magnetic field, which occurs due to the misalignment of the horizontal magnetic field.

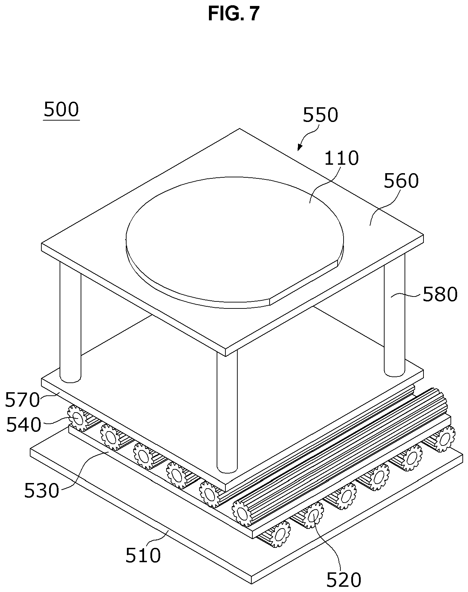

FIG. 7 is a perspective view illustrating the wafer movement stage 500 of the wafer inspection apparatus 100 according to the embodiment of the present invention, the wafer movement stage 500 being capable of moving the wafer 110 backward, forward, leftward, and rightward.

With reference to FIG. 7, the wafer movement stage 500 includes a bearing support 550 on which the wafer 110 and the vertical magnetic field generation unit 400 are arranged, a plurality of first rotational movement bars 540 that move the bearing support 550 backward and forward in a first direction, and a plurality of second rotational movement bars 520 that move the bearing support 550 leftward and rightward in a second direction vertical to the first direction.

The wafer movement stage 500 is required to move horizontally in the forward-backward direction and the leftward-rightward direction of the wafer movement stage 500, that is, in the forward-backward longitudinal direction and the leftward-rightward transverse direction on a surface of the stage 500.

It is possible that the wafer movement stage 500 has various structural forms and operating techniques.

The wafer movement stage 500 may include an additional tilting stage and thus may also be utilized in aligning the horizontal magnetic field.

The bearing support 550 may include an upper bearing support 560 on which the wafer 110 is arranged, a lower bearing support 570 on which the vertical magnetic field generation unit 400 is arranged, and a plurality of vertical support columns 580 that fixedly support edge portions, respectively, of the upper and lower bearing supports 560 and 570.

The plurality of first rotational movement bars 540 are arranged underneath the lower bearing support 570 in such a manner as to be spaced a predetermined distance apart from each other in the first direction, for example, in the longitudinal direction. The plurality of first rotational movement bars 540 rotationally move to move the bearing support 550 backward and forward, that is, in the longitudinal direction, in a surface-contact manner. The first support plate 530 on which the plurality of first rotational movement bars 540 are arranged may be provided underneath the plurality of first rotational movement bars 540.

The plurality of second rotational movement bars 520 are arranged underneath the first support plate 530 in such a manner as to be spaced a predetermined distance apart from each other in the transverse direction that is the second direction vertical to the longitudinal direction. The plurality of second rotational movement bars 520 rotationally move to move the first support plate 530 leftward and rightward in the traverse direction. A second support plate 510 on which the plurality of second rotational movement bars 520 are arranged may be provided underneath the plurality of second rotational movement bars 520.

The plurality of first rotational movement bars 540 rotationally move forward or backward in the first direction or the second direction in a state of being brought into contact with a lower surface of the lower bearing support 570, and the plurality of second rotational movement bars 520 rotationally move forward or backward in the first direction or the second direction in a state of being brought into contact with a lower surface of the first support plate 530. In this manner, a position of the wafer 110 may be changed.

Therefore, the use of the plurality of first rotational movement bars 540 and the plurality of second rotational movement bars 520 enables the wafer 110 to move backward, forward, leftward, and rightward in such a manner as to measure images of all regions of the wafer 110.

In addition, according to the embodiment of the present invention, it is possible to use a wafer movement technique and a wafer fixation technique. However, in the case of the wafer fixation technique, all regions of the wafer 110 may be measured while moving the image measurement unit 200, the horizontal magnetic field generation unit 300, and the vertical magnetic field generation unit 400.

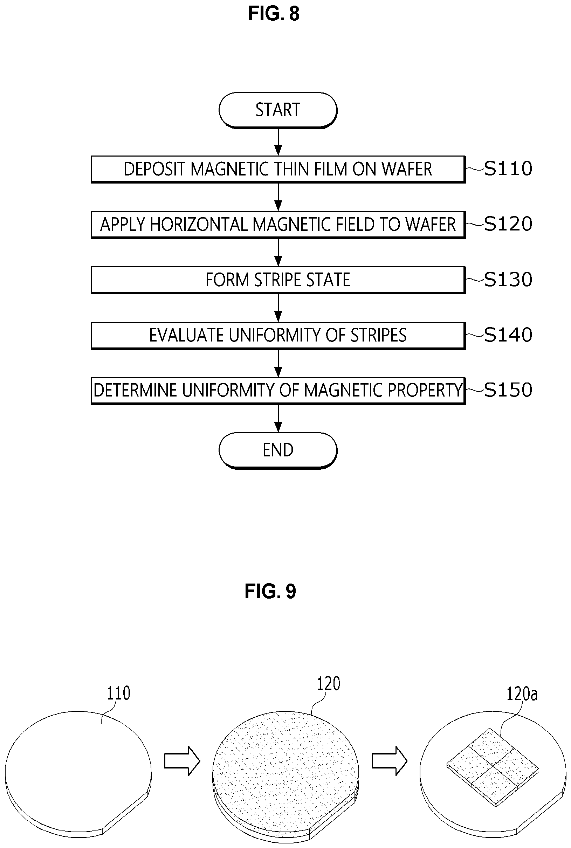

FIG. 8 is a flowchart schematically illustrating a process of measuring the uniformity of a magnetic property of the wafer 110 using the wafer inspection apparatus 100 according to the embodiment of the present invention.

With reference to FIG. 8, first, a magnetic thin film 120 (refer to FIG. 9) is first deposited on a surface of the wafer 110 (refer to FIG. 1) (S110).

Subsequently, using the wafer inspection apparatus 100, the uniformity of the magnetic property may be inspected in a state where only the magnetic thin film is deposited, before patterning the magnetic thin film 120.

Subsequently, a horizontal magnetic field is applied to the magnetic thin film 120 formed on the surface of the wafer 110, using the wafer inspection apparatus 100 (refer to FIG. 1) (S120).

Subsequently, in a state where the horizontal magnetic field is applied, light is emitted to one selected region of the wafer 110 through the image measurement unit 200 (in FIG. 1), thereby forming a stripe state of the magnetic thin film 120 formed on the surface of the wafer 110 (S130).

At this point, when the horizontal magnetic field is applied to the wafer 110, on which the magnetic thin film 120 is deposited, the stripe state is formed.

In an imaging process, this stripe state is only observed and not changed.

Next, the uniformity of stripes in a region of the wafer 110, to which light is emitted through the image measurement unit 200, is evaluated (S140).

Subsequently, the uniformity of the magnetic property of the magnetic thin film 120 on the wafer 110 is determined (S150).

FIG. 9 is a view schematically illustrating the magnetic thin film 120 deposited on top of the wafer 110 and a finely patterned state of the magnetic thin film 120, which are measured using the wafer inspection apparatus 100 according to the embodiment of the present invention.

With reference to 9, the magnetic thin film 120 may be deposited on top of the silicon wafer 110, and a magnetic thin film pattern 120a may be formed by finely patterning the magnetic thin film 120.

At this point, the measurement of the uniformity of the magnetic thin film is performed before patterning the magnetic thin film 120.

A position or the like of a defect in the magnetic thin film 120 may be measured through the wafer inspection apparatus 100 (refer to FIG. 1) according to the embodiment of the present invention before finely patterning the magnetic thin film 120 formed on top of the silicon wafer 110, and the uniformity, amount of magnetization, vertical anisotropy, and the like of the magnetic thin film 120 formed on the surface of the silicon wafer 110 may be checked.

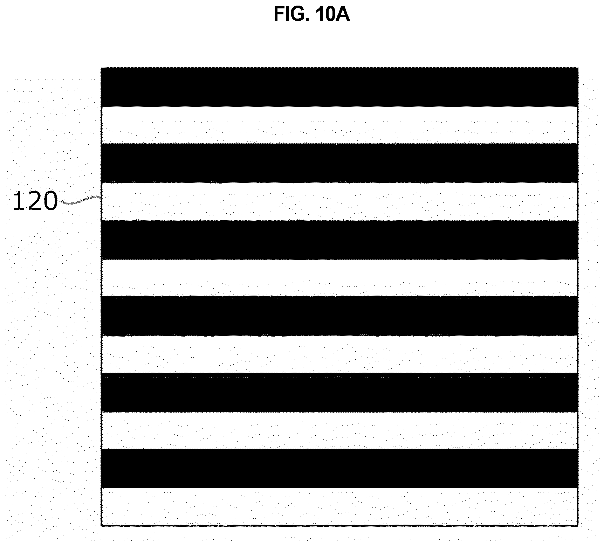

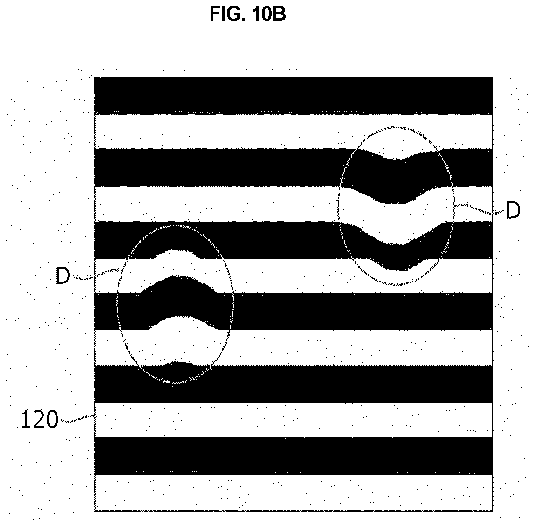

FIG. 10A is a view illustrating a uniform distribution of properties of the stripes on the surface of the wafer 110, which are measured using the wafer inspection apparatus 100 according to the embodiment of the present invention. FIG. 10B is a view illustrating defects in the distribution of the properties of the stripes on the surface of the wafer 110, which are measured using the wafer inspection apparatus 100 according to the embodiment of the present invention.

From 10A, it can be seen that a regular stripe pattern state is observed on the magnetic thin film 120 formed on the surface of the wafer 110, indicating a uniform distribution of the properties.

From FIG. 10B, it can be seen that non-uniform stripe defects D, along with a regular stripe pattern state, are observed on the magnetic thin film 120 formed on the surface of the wafer 110, indicating detects in the distribution of the properties.

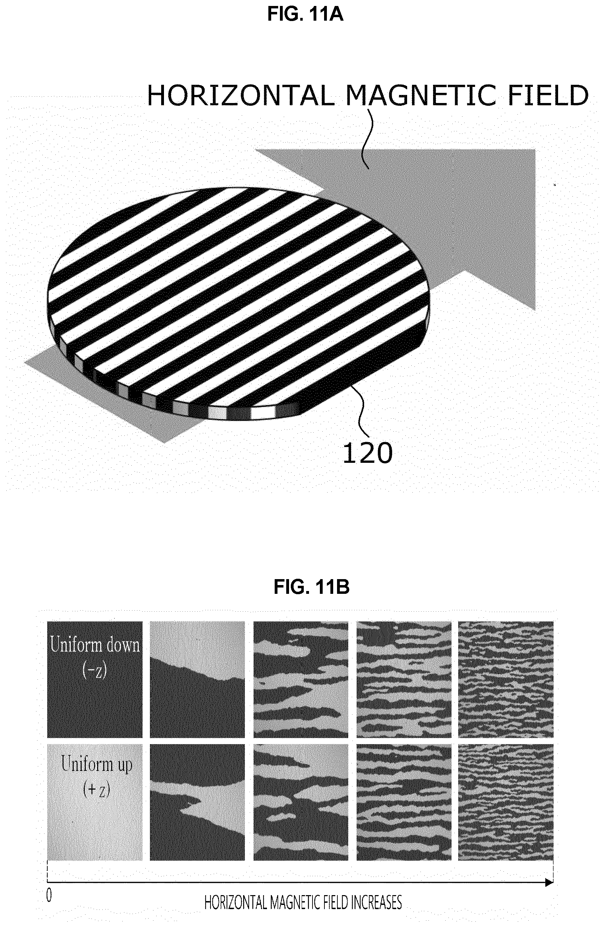

FIG. 11A is a schematic perspective view illustrating a state where the horizontal magnetic field is applied to the surface of the wafer 110 in a parallel manner, using the wafer inspection apparatus 100 according to the embodiment of the present invention. FIG. 11B is a view schematically illustrating the stripe state of the surface of the wafer 110, which results from the intensity of the applied horizontal magnetic field when applying the horizontal magnetic field to the surface of the wafer 110.

With reference to FIG. 11A, the strong horizontal magnetic field is applied in a parallel manner from the horizontal magnetic field generation unit 300 (refer to FIG. 1) toward the magnetic thin film 120 formed on the surface of the wafer 110, thereby forming the stripe state on the magnetic thin film 120 on the wafer 110.

From FIG. 11B, it can be seen that the stripe state changes according to the intensity of the horizontal magnetic field. Particularly, it can be seen that as the horizontal magnetic field increases, uniform stripe patterns are formed on a uniform down-region and a uniform up-region.

When the uniform down-region and the uniform up-region are achieved, the magnitude of the horizontal magnetic field is at its lowest value of zero. Furthermore, the more compact the stripe structure appears, the higher the magnitude of the horizontal magnetic field can become.

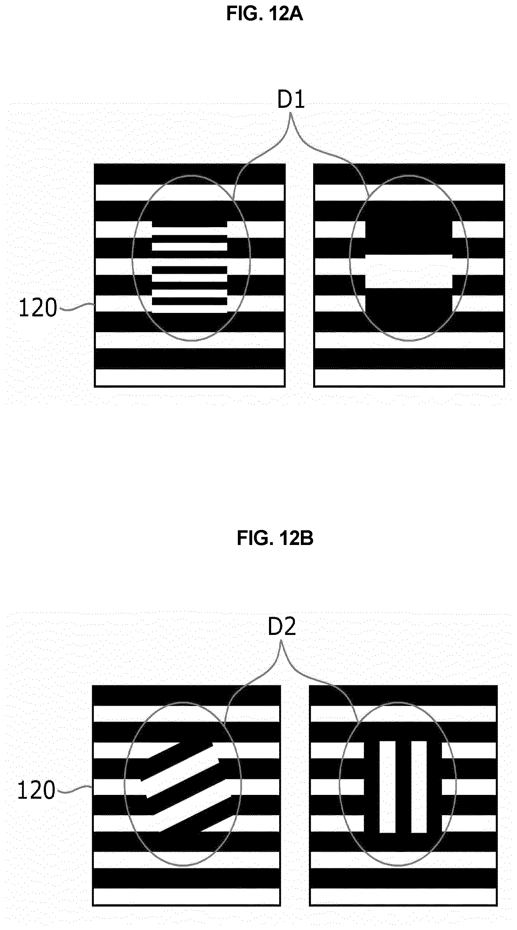

FIG. 12A is a view schematically illustrating non-uniform states of widths of the stripes, which are among defect types of the stripes on the wafer 110, which are measured when applying the horizontal magnetic field in a parallel manner to the surface of the wafer 110, using the wafer inspection apparatus 100 according to the embodiment of the present invention.

FIG. 12B is a view schematically illustrating non-uniform states of directions of the stripes, which are among defect types of the stripes on the wafer 110, which are measured when applying the horizontal magnetic field in a parallel manner to the surface of the wafer 110, using the wafer inspection apparatus 100 according to the embodiment of the present invention.

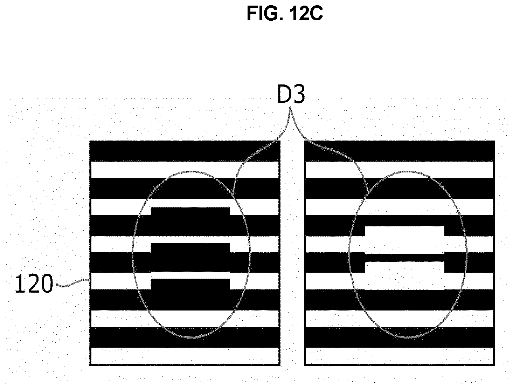

FIG. 12C is a view schematically illustrating non-uniform states of ratios of the stripes, which are among defect types of the stripes on the wafer 110, which are measured when applying the horizontal magnetic field in a parallel manner to the surface of the wafer 110, using the wafer inspection apparatus 100 according to the embodiment of the present invention.

From FIG. 12A, it can be seen that defects D1, indicating non-uniform widths of the stripes, which are among expected defect types of the stripes, are present in one region.

Particularly, it can be seen that in the case of the defects D1, which indicate the non-uniform width of the stripe pattern, the stripe patterns with non-uniform widths are formed, resulting in widths that are smaller or larger than those of the stripe patterns with uniform widths.

From FIG. 12B, it can be seen that defects D2, indicating the non-uniform states of the directions of the stripes, which are among expected defect types of the stripes, are present in one region.

Particularly, it can be seen that in the case of the defects D2, which indicate the non-uniform widths of the directions of the stripes, non-uniform stripe patterns are formed at an inclined angle, differing in direction from those of uniform stripe patterns; or they are formed in a direction vertical to those of uniform stripe patterns.

From FIG. 12C, it can be seen that detects D3, indicating the non-uniform states of the ratios of the stripes, which are among the expected defect types of the stripes, are present in one region.

Particularly, it can be seen that in the case of the defects D3, indicating the non-uniform states of the ratios of the stripes, the stripe patterns with non-uniform width ratios are formed, resulting in ratios that are lower or higher in ratio than those of the stripe patterns with uniform width ratios.

As described above, the wafer inspection apparatus 100 according to the present invention forms the stripe state on the wafer 110 by applying the horizontal magnetic field to the wafer 100. Thus, positions of defects of stripes in all regions of the wafer 110 can be recognized, and the uniformity of the wafer 110 can be evaluated. Consequently, the uniformity of the magnetic property can be effectively measured.

In addition, it is possible that the wafer inspection apparatus 100 according to the present invention moves the position of the wafer 110 in such a manner that all regions of the wafer 110 can be imaged, using the wafer movement stage 500.

The preferred embodiments of the present invention are described above, and it would be clearly understood by a person of ordinary skill in the art that various modifications or alterations to the preferred embodiments can be made within a range that does not depart from the technical idea and scope of the present invention as defined in the following claims.

## Claims

1. A wafer inspection apparatus comprising:
a horizontal magnetic field generation unit arranged proximate to a lateral surface of a wafer and forming a magnetic field in such a manner that lines of magnetic force propagate in a horizontal direction;
a vertical magnetic field generation unit arranged under the wafer and generating a magnetic field canceling out a vertical magnetic field that occurs due to misalignment of a horizontal magnetic field;
an image measurement unit arranged over the wafer and measuring an image of the wafer; and
a wafer movement stage moving the wafer backward, forward, leftward, and rightward.

2. The wafer inspection apparatus of claim 1, wherein the horizontal magnetic field generation unit is arranged proximate to one lateral surface of the wafer, or the horizontal magnetic field generation units are arranged proximate to both lateral surfaces, respectively, of the wafer in such a manner as to face each other.

3. The wafer inspection apparatus of claim 1, wherein the horizontal magnetic field generation unit comprises a horizontal coil support; and a coil wound around the horizontal coil support,
the vertical magnetic field generation unit comprises a vertical coil support arranged under the wafer in a direction vertical to the wafer; and a vertical coil wound around the vertical coil support, and
the image measurement unit comprises a microscope body portion, and a light emission unit.

4. The wafer inspection apparatus of claim 1, wherein the wafer movement stage comprises:
a bearing support on which the wafer and the vertical magnetic field generation unit are arranged;
a plurality of first rotational movement bars that move the bearing support backward and forward in a longitudinal direction in a surface-contact manner;
a plurality of second rotational movement bars that move the bearing support leftward and rightward in a transverse direction; and
a first support plate on which the plurality of first rotational movement bars are arranged and a second support plate on which the plurality of second rotational movement bars are arranged.

5. The wafer inspection apparatus of claim 4, wherein the bearing support comprises:
an upper bearing support on which the wafer is arranged; a lower bearing support on which the vertical magnetic field generation unit is arranged; and
a plurality of vertical support columns fixedly supporting edge portions, respectively, of the upper and lower bearing supports.

6. The wafer inspection apparatus of claim 1, wherein the vertical magnetic field generation unit applies a magnetic field that is capable of changing a magnetized state of the wafer from an up-magnetized state to a down-magnetized state or from the down-magnetized state to the up-magnetized state.

7. The wafer inspection apparatus of claim 1, wherein the vertical magnetic field generation unit is arranged under the wafer and generates a magnetic field canceling out a vertical magnetic field that occurs due to misalignment of a horizontal magnetic field.

8. A wafer inspection apparatus comprising:
a horizontal magnetic field generation unit forming a magnetic field in such a manner that lines of magnetic force propagate in a horizontal direction toward a wafer;
a vertical magnetic field generation unit generating toward the wafer a magnetic field canceling out a vertical magnetic field that occurs due to misalignment of a horizontal magnetic field; and
an image measurement unit measuring an image of the wafer.

9. The wafer inspection apparatus of claim 8, wherein the horizontal magnetic field generation unit is arranged proximate to one lateral surface of the wafer, or the horizontal magnetic field generation units are arranged proximate to both lateral surfaces, respectively, of the wafer in such a manner as to face each other.

10. The wafer inspection apparatus of claim 9, wherein the horizontal magnetic field generation unit comprises a horizontal coil support and a coil wound around the horizontal coil support,
the vertical magnetic field generation unit comprises a vertical coil support arranged under the wafer in a direction vertical to the wafer and a vertical coil wound around the vertical coil support, and
the image measurement unit comprises a microscope body portion and a light emission unit.

11. The wafer inspection apparatus of claim 8, further comprising:
a wafer movement stage moving the wafer backward, forward, leftward, and rightward.

12. The wafer inspection apparatus of claim 11, wherein the wafer movement stage comprises:
a bearing support on which the wafer and the vertical magnetic field generation unit are arranged;
a plurality of first rotational movement bars that move the bearing support backward and forward in a longitudinal direction in a surface-contact manner;
a plurality of second rotational movement bars that move the bearing support leftward and rightward in a transverse direction; and
a first support plate on which the plurality of first rotational movement bars are arranged and a second support plate on which the plurality of second rotational movement bars are arranged.

13. The wafer inspection apparatus of claim 12, wherein the bearing support comprises:
an upper bearing support on which the wafer is arranged;
a lower bearing support on which the vertical magnetic field generation unit is arranged; and
a plurality of vertical support columns fixedly supporting edge portions, respectively, of the upper and lower bearing supports.

14. A method of inspecting a wafer, the method comprising:
forming a magnetic thin film on a wafer;
forming a stripe state by applying a horizontal magnetic field to the wafer; and
determining the uniformity of the wafer by recognizing positions of defects of stripes in all regions of the wafer.

15. The method of claim 14, wherein types of detects of the wafer are inspected by recognizing non-uniform states of widths, directions, or ratios of the stripes.
